# EUROPEAN PATENT SPECIFICATION

(11) **EP 1 362 132 B1**
(45) Date of publication and mention of the grant of the patent: **10.05.2006**
(21) Application number: 02718966.1
(22) Date of filing: 14.02.2002
(51) Int. Cl.: C23C 14/34, B22F 7/06

(54) **Rejuvenation of a tantalum sputtering target.**
Reparatur von Tantalsputtertargets.
Dépannage des cibles de pulvérisation de Tantalum

(30) Priority: 14.02.2001 US 268742 P
(43) Date of publication of application: 19.11.2003
(73) Proprietor: H. C. Starck, Inc., Newton, MA 02461 (US)
(72) Inventor: AIMONE, Paul; c/o H. C. Starck, Inc., Newton, MA 02461 (US); KUMAR, Prabhat; c/o H. C. Starck, Inc., Newton, MA 02461 (US); JEPSON, Peter R.; c/o H. C. Starck, Inc., Newton, MA 02461 (US); UHLENHUT, Henning; H.C. Starck, Newton, MA 02461-1951 (US); GOLDBERG, Howard, V.; H.C. Starck, Newton, MA 02461-1951 (US)
(74) Representative: Zobel, Manfred
(86) International application number: PCT/US2002/004306
(87) International publication number: WO 2002/064287

(56) References cited:
- EP-A- 0 834 594
- EP-A1- 0 834 594
- WO-A1-00/31310
- DE-A- 19 626 732
- DE-A- 19 925 330
- DE-A1- 19 626 732
- DE-A1- 19 925 330
- ABBOTT D H ET AL: "LASER FORMING TITANIUM COMPONENTS" ADVANCED MATERIALS & PROCESSES, AMERICA SOCIETY FOR METALS. METALS PARK, OHIO, US, vol. 153, no. 5, May 1998 (1998-05), pages 29-30, XP001120282 ISSN: 0882-7958
- ARCELLA F G ET AL: "PRODUCING TITANIUM AEROSPACE COMPONENTS FROM POWDER USING LASER FORMING" JOM, MINERALS, METALS AND MATERIALS SOCIETY, WARRENDALE, US, vol. 52, no. 5, May 2000 (2000-05), pages 28-30, XP001157479 ISSN: 1047-4838

## Description

### FIELD AND BACKGROUND OF THE INVENTION

The purpose of the invention is to decrease the recycling cost of rejuvenating tantalum sputtering targets having backing plate structures attached.

For example, sputtering targets of high temperature materials, such as tantalum and other refractory metals (Ta, Nb, Ti, Mo, Zr, metals and alloys; hydrides, nitrides and other compounds thereof) used in integrated circuit manufacture and other electrical, magnetic and optical product manufacture usually are eroded in a non-uniform way during the process of sputtering which leads to a race track like trench on the operating side of the target. In order to prevent any contamination of the substrates or catastrophic break-through of coolant fluids behind the target, the targets generally are withdrawn from service well before the refractory sputter metal is penetrated, accepting the need for a new target after only a minor portion of the sputter metal has been consumed. The major part of the sputter target can be resold only at scrap price or recycled with difficulty and apart from this, the backing plate of the target needs to be removed and may be re-bonded to a new sputter metal plate for recycling. DE 196 26 732 discloses a process of repairing sputtering targets by dipping a heating element into the molten metal. As an example a sputtering target made of tin was repaired.

It is a principal object of the invention to replace such current recycling practice by rejuvenation of tantalum sputtering targets as described below.

It is an object of the invention to improve the cost and speed of getting used sputtering targets back into service.

It is a further object of the invention to establish a microstructure of the fill zone at least as good as on the balance of the target.

### SUMMARY OF THE INVENTION

The present invention as given in the claims a method to rejuvenate surfaces of used refractory tantalum sputtering targets by filling consumed surface areas with consolidated powder metal. For example, a race track trench or other erosion zone is produced on the face of a sputtering target after numerous non-uniform bombardments of argon atoms. The consumed surface is rejuvenated by the placement or deposition of tantalum and sinter bonding by laser or EB heating for sintering or plasma discharge coupled with deposition. Use of these methods will yield a fully dense coating. This avoids the need for decoupling the tantalum from the copper, filling the erosion zone of the tantalum plate with tantalum powder and HIP (hot isostatic pressing) bonding and reassembly. In the case of laser or EB scan sintering or plasma discharge coupled with deposition the target can be rejuvenated without separating the backing plate from the target. The various forms of rejuvenation produce a filled erosion zone with microstructure similar to the balance of the target.

The invention can be applied to tantalum targets. (whether or not mounted on a non-refractory metal carrier) that are subject to non-uniform erosion, etching, chipping or other metal loss.

The rejuvenation of a tantalum target eliminates the need to recycle the whole product after only a minor share of the product has been consumed. Such rejuvenation can be more economical than recycling the whole target. Separation of the bonded backing plate (e.g. copper), if any, may not be needed. This rejuvenation can be practiced repeatedly, as many times as desired.

Other objects, features and advantages will be apparent from the following detailed description of preferred embodiments taken in conjunction with the accompanying drawings in which:

### BRIEF DESCRIPTION OF THE DRAWINGS

FIG. 1 shows a cross section of typical target and backing plate;
FIG. 2 shows a face view including a usual erosion zone;
FIG. 3 is a block diagram of the rejuvenation process; and
FIG. 4 shows in outline form a vacuum or inert gas chamber set-up for practice of the invention.

### DETAILED DESCRIPTION OF PREFERRED EMBODIMENTS

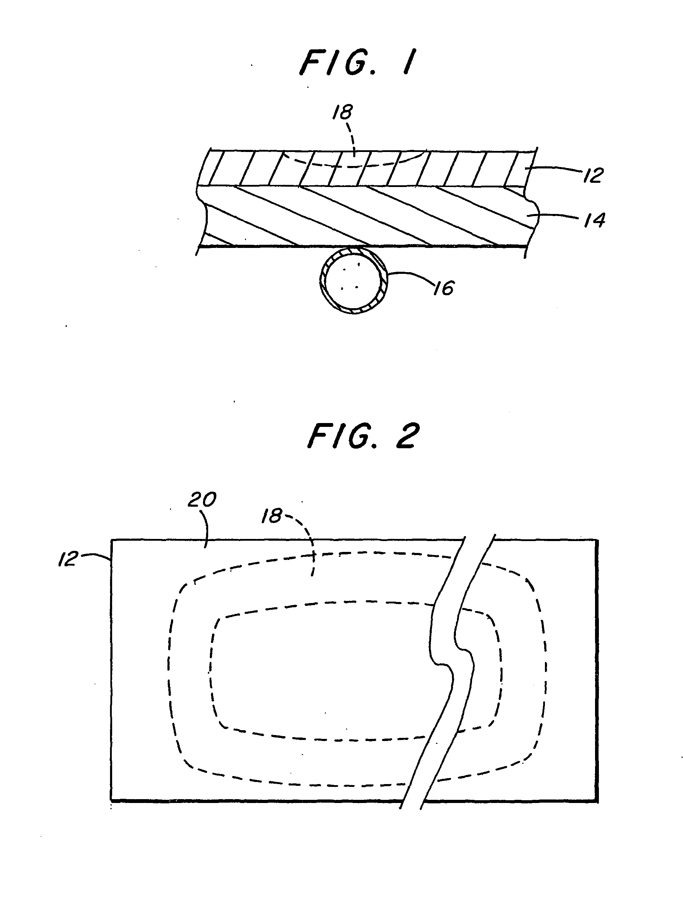

Now turning to FIGS. 1 and 2, a tantalum (Ta) sputter plate 12 bonded to a copper (Cu) backing plate 14 is presented to illustrate the rejuvenation process of the present invention. In addition to the backing plate, the sputter target may include additional complexity such as bonded-on water cooling coils 16 or even be part of a large cooling liquid reservoir and/or have complex flanges and mechanical and electrical attaching structures. 18 indicates a typical racetrack form erosion zone or consumed area on the target surface 20 of the sputter plate 12 arising from sputtering usage.

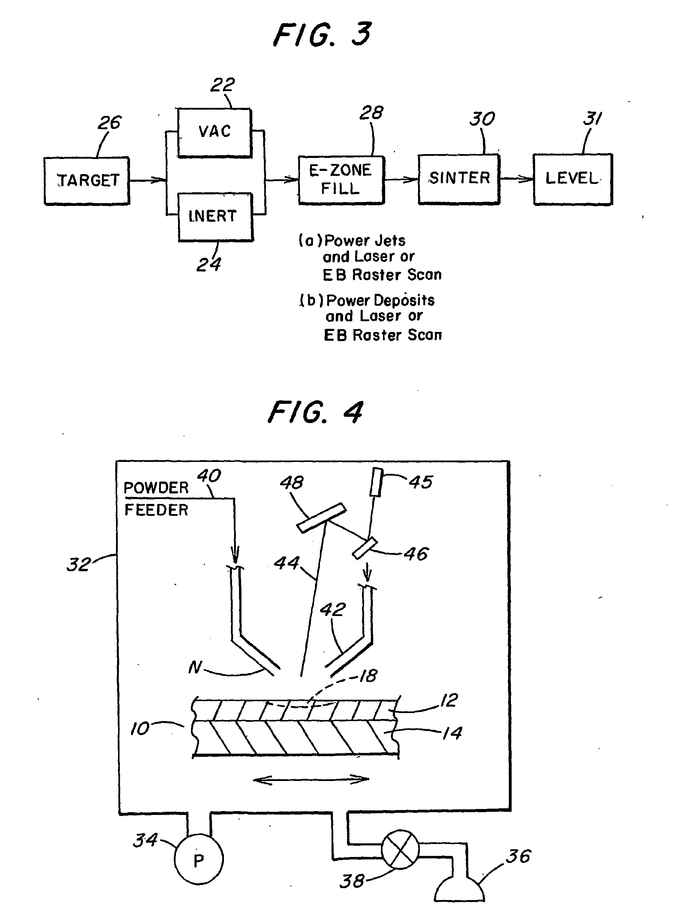

A flow chart of the implementation of the preferred embodiment of the present invention is illustrated in FIG. 3. A vacuum 22 or inert gas zone 24 is established for a used Ta-Cu target 26 assembly. The erosion zone 18 or consumed area of the sputter plate 12, as shown in FIG. 2, is filled with powders of the sputter metal. The powders are bonded or sintered 30 to the sputter plate 12 by laser or electron beam raster scanning to melt powder surfaces, but not complete particles or the entire particle that act as nuclei for grain growth. The melting can be done during powder deposition or after deposition on a layer-on-layer basis. A powder derived foil can also be pre-made and laid into the trench. In all cases the fill is sintered for self bonding and adhesion to the target and leveled 31 off by machining, sanding or other abrasion etching and/or a burn-in sputtering process.

The following is one of several examples of how the invention can be implemented.

As shown in FIG. 4, a sputtering target 10 can be placed in a vacuum chamber 32 evacuated atmospheric pressure purified inert gas (argon) atmosphere utilizing conventional pump 34 and gas back-fill apparatus 36 with valve 38. A powder feeder 40 comprising multiple nozzles 42 can insert multiple high velocity streams of Ta powder of -100 to 325 mesh to the erosion zone 18 or consumed area. The powder feeder 40 can scan along the erosion zone 18 or the target can be moved relative to a fixed powder feeder. A 15-20 KW (preferably 20-25) laser beam 44 formed by a laser 45 and conventional scan optics 46, 48 which can be wholly in the chamber 32 or partly outside the chamber 32 using a window for beam passage can be traced in raster scan fashion over the erosion zone 18, as the powder falls, to melt powder particle surfaces and enable particle to particle bonding and bonding to the base of the erosion zone continuously and repeatedly around the zone 18 until it is filled. Powder mass calculations and/or optical monitors can be used to determine completion and a cut-off of filling.

One form of equipment usable for such processing is the Lasform brand direct metal deposition system of AeroMet Corp., as described, e.g., in Abbott et al., "Laser Forming Titanium Components" in the May 1998 issue of Advanced Metals & Processes and Arcella et al., "Producing Titanium Aerospace Components From Powder Using Laser Forming," Journal of Metals (May 2000), pp. 28-30.

The laser can provide post-fill heating to complete the sintering. Separate target heaters can be used to preheat the target or provide additional heat during the rejuvenation.

The various forms of rejuvenation produce a filled erosion zone or consumed area with microstructure similar to the balance of the target. For example, filled erosion zone specimens from a sputtering target were analyzed for the electron beam raster scanning method. The hardness was typical for rolled and annealed tantalum plate with normal variation. The filled erosion zones were substantial free of porosity and inclusions. The yield strength and ultimate yield strength met ASTM requirements.

In another embodiment of the invention, the well unknown process of plasma deposition can be utilized to combine the powder placement and fusing steps.

## Claims

1. A method to rejuvenate a consumed tantalum sputtering target comprising the steps:
providing a used tantalum sputtering target having a tantalum sputtering plate and a backing plate, wherein a target face of said tantalum sputtering plate includes one for more consumed surface area portions;
providing a powder of tantalum;
selectively supplying a tantalum powder to partially or completely fill each of said one or more consumed surface area portions of the tantalum plate to form filled portions; and
applying a short term, high powdered radiant energy beam locally to said filled portions to bond powder particles of said tantalum powder to each other and to said each of one or more consumed surface area portions to form a mass of bonded tantalum particles,
whereby the energy beam being traced in a raster scan fashion over the consumed surface area portions, as the powder falls, to melt the powder particle surfaces and enable particle to particle bonding and bonding to the base of the consumed surface area continuously and repeatedly until it is filled and said used tantalum sputtering target is rejuvenated without separating said backing plate from said tantalum sputtering plate.

2. The method of rejuvenating a consumed tantalum sputtering as defined in claim 1 further comprising the step removing excess of said mass of bonded tantalum metal particles to level said tantalum sputtering plate.

3. The method of rejuvenating a consumed tantalum sputtering target as defined in claim 1 wherein said energy beam is laser beam, electron beam or the bonding step is plasma deposition.

4. The method of rejuvenating a consumed tantalum sputtering target as defined in claim 1 wherein said energy beam is applied in a vacuum environment.

5. The method of rejuvenating a consumed tantalum sputtering target as defined in claim 1 wherein said energy beam is applied in an inert gas environment.

6. The method of rejuvenating a consumed tantalum sputtering target as defined in claim 2 wherein the step removing excess of said mass of bonded metal particles to level the sputter plate is machining, sanding, abrasion etching or burn in sputtering.

7. The method as defined in claim 1, wherein the energy beam provides post-fill heating to complete the sintering.

## Patentansprüche

1. Verfahren zur Regeneration eines verbrauchten Tantalsputtertargets, folgende Schritte umfassend:
das Bereitstellen eines gebrauchten Tantalsputtertargets mit einer Tantalsputterplatte und einer Grundplatte, worin eine Targetfläche der Tantalsputterplatte eine oder mehrere verbrauchte Oberflächenabschnitte umfasst;
das Bereitstellen eines Tantalpulvers;
das selektive Auftragen eines Tantalpulvers, um jede der genannten einen oder mehreren verbrauchten Oberflächenabschnitte der Tantalplatte teilweise oder vollständig aufzufüllen und so aufgefüllte Abschnitte bereitzustellen; und
das Anlegen eines kurzzeitigen, hochenergetischen Strahlungsenergiestrahls lokal auf die aufgefüllten Abschnitte, um Pulverteilchen des Tantalpulvers aneinander und an jeden der einen oder mehreren verbrauchten Oberflächenabschnitte zu binden, um eine Masse aus gebundenen Tantalteilchen zu bilden,
wobei der Energiestrahl auf Rasterabtastungsweise über die verbrauchten Oberflächenabschnitte geführt wird, wie das Pulver darauffällt, um die Pulverteilchenoberflächen zu schmelzen und eine kontinuierliche und wiederholte Teilchenan-Teilchen-Bindung und eine Bindung an die Basis der verbrauchten Oberfläche zu ermöglichen, bis diese aufgefüllt ist und das verbrauchte Tantalsputtertarget regeneriert ist, ohne dass die Grundplatte von der Tantalsputterplatte abgetrennt wird.

2. Verfahren zur Regeneration eines verbrauchten Tantalsputtertargets nach Anspruch 1, ferner den Schritt des Entfernens überschüssiger Masse aus gebundenen Tantalmetallteilchen umfassend, um die Tantalsputterplatte zu nivellieren.

3. Verfahren zur Regeneration eines verbrauchten Tantalsputtertargets nach Anspruch 1, worin der Energiestrahl ein Laserstrahl oder Elektronenstrahl ist oder der Bindungsschritt Plasmaabscheidung ist.

4. Verfahren zur Regeneration eines verbrauchten Tantalsputtertargets nach Anspruch 1, worin der Energiestrahl in einer Vakuumumgebung angelegt wird.

5. Verfahren zur Regeneration eines verbrauchten Tantalsputtertargets nach Anspruch 1, worin der Energiestrahl in einer Inertgasumgebung angelegt wird.

6. Verfahren zur Regeneration eines verbrauchten Tantalsputtertargets nach Anspruch 2, worin der Schritt des Entfernens überschüssiger Masse aus gebundenen Metallteilchen, um die Sputterplatte zu nivellieren, aus Spanen, Schmirgeln mit Sand, Schleifätzen oder Einbrennsputtern besteht.

7. Verfahren nach Anspruch 1, worin der Energiestrahl Hitze nach dem Auffüllen bereitstellt, um den Sintervorgang abzuschließen.

## Revendications

1. Procédé de régénération d'une cible de pulvérisation de tantale consommée comprenant les étapes consistant à :
fournir une cible de pulvérisation de tantale usée présentant une plaque de pulvérisation de tantale et une plaque de support, dans lequel une face de cible de ladite plaque de pulvérisation de tantale comprend une ou plusieurs parties d'aire de surface consommées ;
fournir une poudre de tantale ;
fournir sélectivement une poudre de tantale afin de remplir partiellement ou complètement chacune desdites une ou plusieurs parties d'aire de surface consommées de la plaque de tantale pour former des parties remplies ; et
appliquer localement un faisceau d'énergie rayonnante à haute puissance brièvement sur lesdites parties remplies pour lier les particules de poudre de ladite poudre de tantale les unes aux autres et sur chacune de la ou des parties d'aire de surface consommées pour former une masse de particules de tantale liées,
moyennant quoi le faisceau d'énergie est tracé à la manière d'un balayage de trame sur les parties d'aire de surface consommées, au fur et à mesure que la poudre tombe, pour fusionner les surfaces des particules de poudre et permettre une liaison de particule à particule et une liaison sur la base de l'aire de surface consommée d'une façon continue et répétée jusqu'à ce qu'elle soit remplie, et que ladite cible de pulvérisation de tantale usée soit régénérée sans séparer ladite plaque de support de ladite plaque de pulvérisation de tantale.

2. Procédé de régénération d'une cible de pulvérisation de tantale consommée selon la revendication 1, comprenant en outre l'étape d'élimination de l'excès de ladite masse de particules métalliques de tantale liées pour égaliser ladite plaque de pulvérisation de tantale.

3. Procédé de régénération d'une cible de pulvérisation de tantale consommée selon la revendication 1, dans lequel ledit faisceau d'énergie est un faisceau laser, un faisceau d'électrons, ou l'étape de liaison est un dépôt de plasma.

4. Procédé de régénération d'une cible de pulvérisation de tantale consommée selon la revendication 1, dans lequel ledit faisceau d'énergie est appliqué dans un environnement sous vide.

5. Procédé de régénération d'une cible de pulvérisation de tantale consommée selon la revendication 1, dans lequel ledit faisceau d'énergie est appliqué dans un environnement de gaz inerte.

6. Procédé de régénération d'une cible de pulvérisation de tantale consommée selon la revendication 2, dans lequel ladite étape d'élimination de l'excès de ladite masse de particules métalliques liées pour égaliser la plaque de pulvérisation est exécutée par usinage, sablage, attaque abrasive ou brûlage pendant la pulvérisation.

7. Procédé selon la revendication 1, dans lequel le faisceau d'énergie exécute un chauffage après le remplissage pour terminer le frittage.
